# EUROPÄISCHE PATENTSCHRIFT

(11) **EP 1 667 836 B1**
(45) Veröffentlichungstag und Bekanntmachung des Hinweises auf die Patenterteilung: **17.07.2013**
(21) Anmeldenummer: 04816228.3
(22) Anmeldetag: 30.09.2004
(51) Int. Cl.: B29C 59/02, G03F 7/00, B29C 59/04, B44B 5/00, B44B 5/02, B29C 39/08

(54) **WERKZEUG UND VERFAHREN ZUM ERZEUGEN EINER MIKROSTRUKTURIERTEN OBERFLÄCHE**
TOOL AND METHOD FOR PRODUCING A MICROSTRUCTURED SURFACE
OUTIL ET PROCEDE DE FABRICATION D'UNE SURFACE MICROSTRUCTUREE

(30) Priorität: 01.10.2003 DE 10346124
(43) Veröffentlichungstag der Anmeldung: 14.06.2006
(73) Patentinhaber: Fraunhofer-Gesellschaft zur Förderung der angewandten Forschung e.V., 80686 München (DE)
(72) Erfinder: STENZEL, Volkmar, 27321 Thedinghausen (DE); KAUNE, Martin, 28213 Bremen (DE); DA SILVA BRANCO CHETA, Marta, Raquel, 28357 Bremen (DE)
(74) Vertreter: Eisenführ, Speiser & Partner
(86) Internationale Anmeldenummer: PCT/EP2004/052383
(87) Internationale Veröffentlichungsnummer: WO 2005/030472

(56) Entgegenhaltungen:
- EP-A- 1 003 078
- EP-A- 1 366 888
- WO-A-00/30869
- DE-A1- 4 207 210
- DE-C1- 10 203 250
- US-A1- 2002 098 257
- PATENT ABSTRACTS OF JAPAN Bd. 015, Nr. 473 (M-1185), 29. November 1991 (1991-11-29) -& JP 03 203623 A (CHISSO CORP), 5. September 1991 (1991-09-05)

## Beschreibung

Die Erfindung betrifft ein Werkzeug zum Erzeugen einer mikrostrukturierten Oberfläche, sowie ein Verfahren zum Erzeugen einer wenigstens teilweise mikrostrukturierten Oberfläche.

Mikrostrukturierte Oberflächen werden in zunehmendem Maße für spezielle Funktionen benötigt. Beispielhaft zu nennen sind hier Oberflächen mit der Lotusblattstruktur oder strömungsbegünstigte Oberflächen. Produkte, die mit strömungsbegünstigten, sogenannten "Riblet"-Oberflächen hinsichtlich Geschwindigkeit und Energieverbrauch optimiert werden können, sind grundsätzlich Objekte, die einerseits selbst bewegt werden, wie beispielsweise Flugzeuge, Schienenfahrzeuge, Automobile, Schiffe oder auch Rotorblätter von Windkraftanlagen und andererseits Objekte, um die herum oder durch die eine Bewegung stattfinden soll, wie z.B. Pipelines. Zusätzlich dienen mikrostrukturierte Oberflächen dazu, Verschmutzungen oder Bewuchs (insbesondere bei Schiffen) zu vermindern.

Derartige Oberflächenstrukturen werden häufig durch Extrusions- oder Prägeverfahren als Folien erzeugt, die anschließend auf das jeweilige Werkstück geklebt werden. Dieses Verfahren hat folgende Nachteile:
- Die Klebung einer Folie auf doppelt gekrümmten Flächen (z.B. auf Flugzeugtragflächen oder Rotoren für Windkraftanlagen) ist schwierig bis unmöglich.
- Die Klebung kann sich im Betrieb ablösen.
- Eine Folie bringt zusätzliches Gewicht auf das Werkstück. Dies wirkt der beabsichtigten Energieeinsparung beispielsweise im Falle von strömungsbegünstigten Oberflächen an Fahrzeugen entgegen.
- Zusätzlich verbraucht eine Folie auch Volumen, was im Falle von Pipelines zu einem verringerten Innenvolumen oder dem Bedarf an einem vergrößerten Außenvolumen führt.

Zur Strukturierung von Folien sind Prägeverfahren bekannt, die Folien oder folienartige Materialien in stationären Maschinen prägen. So offenbaren Reiner Mehnert, A. Sobottka und Ch. Elsner in "Microstructured Polyacrylate Surfaces Generated by UV&EP Curing", Proc. RadTech Europe, 08.-10., Basel (2001) 603-608 eine Vorrichtung, bei der eine Folie über eine Walze geführt wird, deren Oberfläche als Matrize ausgebildet ist. Gleichzeitig mit dem Abdruck der Matrize in die Folie wird die (zukünftige) Oberfläche der Folie durch Durchstrahlen der Folie mit Elektronen oder UV-Strahlung ausgehärtet.

Eine ähnliche Vorrichtung wird auch in der DE 196 13 383 C1 offenbart, in der eine Gelatinefolienbahn zwischen zwei Walzen hindurchgeführt wird, wobei eine von den Walzen an ihrer Oberfläche eine Matrize umfasst.

Die EP 0 205 289 A1 offenbart ein Verfahren, in dem ebenfalls über eine Walze eine Mikrostruktur auf eine Folie angebracht wird.

Den drei genannten Verfahren bzw. Vorrichtungen ist gemein, dass das Material, dessen Oberfläche mikrostrukturiert werden soll, flexibel sein muss, so dass es über die Andruckwalze geführt werden kann. Keines dieser Dokumente zeigt eine Möglichkeit auf, mittels derer man mit einer Walze eine Mikrostruktur auf die Oberfläche eines unflexiblen, starren Gegenstandes wie beispielsweise eines Fahrzeugbauteiles aufbringen kann. Insbesondere liefern die erwähnten Vorrichtungen oder Verfahren keinen Hinweis darauf, wie man oder dass man auf eine Folie verzichten könnte. Damit ist eine Prägung (also eine Mikrostruktur) von doppelt gekrümmten, starren Flächen nicht möglich. Zusätzlich erschwerend kommt hinzu, dass - falls die Prägung mit einem gleichzeitigen (teilweisen) Aushärten der mikrostrukturierbaren Oberfläche verbunden ist - dieses Aushärten durch Durchstrahlen der jeweiligen Folie geschehen muss, da die mikrostrukturierbare Seite der Folie von der Matrize und der diese tragenden Walze verdeckt ist. Ein solches Aushärten ist naturgemäß beim Mikrostrukturieren größerer, nicht durchstrahlbarer Gegenstände - wie etwa Bauteilen von Fahrzeugen - nicht möglich.

Um keine Folie verwenden zu müssen, wäre es im Grunde günstig, einen Lack, der z.B. auf Fahrzeugoberflächen aufgebracht wird, direkt zu strukturieren. Eine Prägung des noch nicht ausgehärteten Lackes durch einen kurzzeitigen Kontakt mit einem Prägewerkzeug ist aber nicht in einer für bestimmte Anwendungen (z.B. für eine strömungsgünstige Oberfläche) ausreichenden Qualität ohne weiteres möglich, da herkömmliche Nasslacke kein Zeitfenster bieten, innerhalb dessen der Lack noch verformbar ist und andererseits nach dem Kontakt mit dem Prägewerkzeug nicht mehr verfließt. Darüber hinaus ist der Lack im nichtausgehärteten Zustand extrem klebrig und bleibt beim Abnehmen des Prägewerkzeugs daran kleben, auch wenn die Oberflächenenergie des Prägewerkzeugs extrem niedrig ist (z.B. kleiner als 25 mN/M).

Verfahren zur Nano- und Mikrostruktur von Lacken sind bekannt, z.B. um Hologramme in der Lackschicht zu erzeugen. So offenbart beispielsweise die WO 00/30869 ein Verfahren zur dekorativen Gestaltung einer lackierten Substratoberfläche, bei dem ein durch UV-Strahlung vernetzbarer Lack durch eine Matrize hindurch mittels UV-Strahlung ausgehärtet wird.

Auch in der bereits erwähnten DE 196 13 383 C1 ist eine durchstrahlbare Matrize offenbart; die Aushärtung der mikrostrukturierbaren Oberfläche erfolgt mittels UV-Strahlung durch die Matrize hindurch.

Die WO 00/30869A offenbart ebenfalls ein Verfahren zum Mikrostrukturieren einer Oberfläche.

Keine der genannten Schriften offenbart jedoch einen Hinweis auf ein Werkzeug, mit dem man große und gegebenenfalls doppelt gekrümmte Flächen mikrostrukturieren kann, ohne dass Folien oder extrem große Matrizen eingesetzt werden müssten oder (kleinere) Matrizen immer wieder aufzulegen und abzunehmen wären.

Die US 2002/098257 A1 offenbart ein Werkzeug zum Erzeugen einer Mikrostruktur mit einer Andruckwalze. Nicht offenbart ist jedoch, dass die Andruckwalze über eine Oberfläche verfahrbar ist, so dass die Mikrostrukturierung großer Flächen extrem aufwendig wäre.

Aufgabe der vorliegenden Erfindung war es daher, ein Werkzeug anzugeben, mit dem es mit geringem Aufwand möglich ist, eine Mikrostruktur auch auf unflexible, undurchstrahlbare Werkstoffe und dabei insbesondere auf größere Flächen aufzubringen.

Erfindungsgemäß wird diese Aufgabe gelöst durch ein Werkzeug zum Erzeugen einer mikrostrukturierten Oberfläche, umfassend:
- eine flexible Matrize mit einem Negativ der zu erzeugenden Mikrostruktur
- eine über eine Oberfläche verfahrbare Andruckwalze zum Andrücken der Matrize an die Oberfläche,
wobei Andruckwalze und Matrize so angeordnet sind, dass beim Verfahren der Walze über die Oberfläche die Matrize in eine rollenden Bewegung zwischen Walze und Schicht gelangt, so dass das Negativ der Matrize der Oberfläche zugewandt ist, und eine Vorrichtung zum Beschleunigen des Aushärtens eines aushärtbaren Materials so angeordnet ist, dass sie beim Verfahren der Andruckwalze über die Oberfläche deren Bewegung begleitet und auf einen Teil der Oberfläche einwirkt.

Dabei ist unter "Erzeugen einer mikrostrukturierten Oberfläche" die Erzeugung einer Oberflächentopographie zu verstehen, die im wesentlichen Strukturen im Bereich von 100 µm bis 0,5 µm bevorzugt 50 µm bis 0,5 µm Abstand zueinander und Tiefe umfasst. Falls das Erzeugen durch Abformen (z.B. Prägen) erfolgt, ist der Fehler der Abformung (Abweichung von der Sollform) dabei kleiner als 5 µm, bevorzugt kleiner 1 µm. Diese Oberfläche kann Teil einer speziellen Schicht auf einem Substrat (beispielweise ein Lack auf einer Flugzeugtragfläche) sein oder durch das Substrat selbst gebildet werden. Die genannte Topographie wird regelmäßig durch Prägen und - falls die geprägte Oberfläche nicht bereits formstabil ist - nachfolgendes Aushärten erzeugt.

Unter einer "werfahrbaren" Andruckwalze ist eine Andruckwalze zu verstehen, deren Schwerpunkt eine Bewegung auf einer mikrostrukturierbaren Oberfläche bzw, einem Substrat, auf dem eine solche Oberfläche aufgebracht wird, durchzuführen vermag. Dementsprechend ist unter einem "Verfahren" der Walze über eine Oberfläche das Bewegen des Schwerpunktes dieser Walze entlang der genannten Oberfläche zu verstehen, wobei sich die Walze rollend bewegt.

Unter Aushärten ist im Rahmen dieses Textes ein wenigstens teilweises Aushärten zu verstehen.

Der Vorteil einer Vorrichtung zum Aushärten eines aushärtbaren Materials liegt ' darin, dass bei ihrer Verwendung - die Anpassung des verwendeten aushärtbaren Materials (z.B. eines Lacksystems) an den Wirkmechanismus der Vorrichtung vorausgesetzt - durch die Aushärtung ein Verlaufen des aushärtbaren Materials, in das die Mikrostruktur durch die Matrize eingebracht wurde, verringert oder sogar vermieden wird.

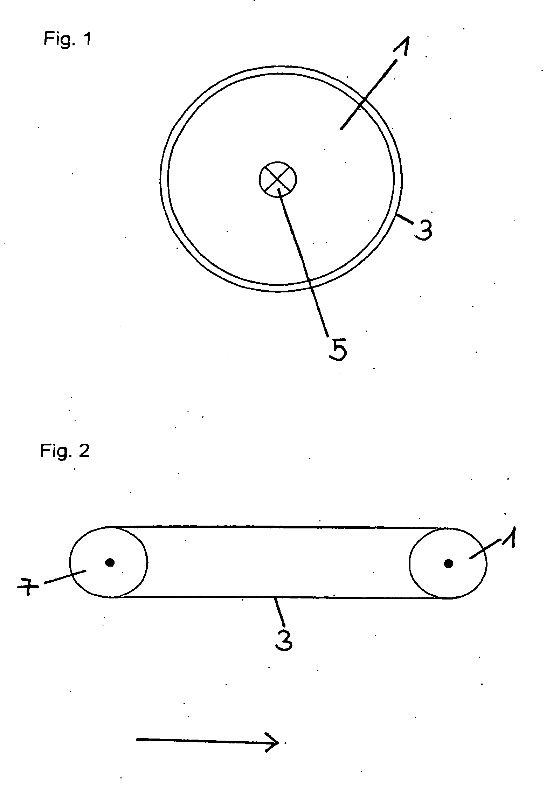

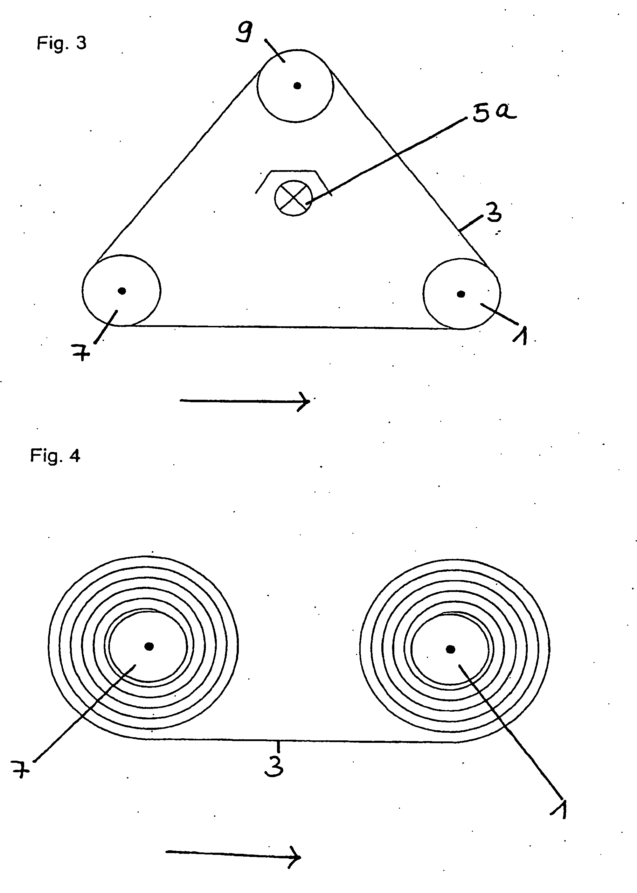

Die Figuren 1 bis 5, auf die weiter unten noch im Detail eingegangen wird, stellen jeweils eine schematische Darstellung eines erfindungsgemäßen Werkzeuges dar, wobei die eingezeichnete Lichtquelle (5, 5a) jeweils optional ist, also ein Beispiel für eine Vorrichtung zum Aushärten eines aushärtbaren Materials darstellt. Dementsprechend ist es z.B. möglich, dass die Matrize (a) in Form eines Endlosbandes um nur eine Walze (Figur 1), zwei (Figur 2) oder drei (vgl. z.B. Figur 3) und mehr Walzen oder (b) in Form eines z.B. an die Länge der zu mikrostrukturierenden Fläche angepassten Einmalbandes (insbesondere zur Erzeugung von nicht identisch wiederkehrenden Mikrostruktursmustern) über zwei (vgl. Figur 4) oder mehr als zwei Walzen geführt wird, wobei das Einmalband z.B. von einer ersten Walze ab- und von einer zweiten Walze aufgewickelt wird. Der Fachmann wird leicht weitere Gestaltungsmöglichkeiten des erfindungsgemäßen Werkzeugs auffinden.

Wichtig für die Ausgestaltung des erfindungsgemäßen Werkzeugs ist die Auswahl eines geeigneten Matrizenmaterials. Dieses Material sollte Strukturen im Bereich von weniger als 20 Mikrometern, bevorzugt weniger als 5 Mikrometern, wiederum bevorzugt 1 Mikrometer exakt reproduzieren können, es sollte vorzugsweise im ausgehärteten Zustand eine niedrige Oberflächenenergie von ≤ 30 mN/m, bevorzugt ≤ 25 mN/m aufweisen und dadurch mit einem aushärtenden Lack keine starken Adhäsionskräfte aufbauen, und es sollte bevorzugt eine Shore-Härte von 25 bis 50, vorzugsweise 25 bis 40, besonders bevorzugt etwa 27 oder etwa 36 besitzen. Die mit diesen Shore-Härten einhergehende Elastizität ist für den Mikrostruktursvorgang besonders geeignet. Eine Erhöhung der Shore-Härte führt häufig zu deutlich schlechteren Mikrostruktursergebnissen, da die Elastizitätsverringerung insbesondere zu einer Verschlechterung der Mikrostruktur gekrümmter Flächen führt. Eine Verringerung der Shore-Härte unter die angegebenen Werte führt ebenfalls häufig zu einer Verschlechterung der Mikrostruktur, da hierdurch die benötigte Kraft zur Abformung (Prägung) nicht mehr so gut auf die mikrostrukturierbare Oberfläche übertragen wird.

Für bevorzugte Ausführungsformen ist das Matrizenmaterial transparent und besitzt nur eine geringe Absorption im Wellenlängenbereich der verwendeten Strahlung, insbesondere von UV-Licht oder besitzt eine hohe Wärmeleitfähigkeit, um thermische Energie auf die mikrostrukturierbare Oberfläche zu übertragen, vorzugsweise ohne sich dabei selbst zu verformen.

Dem Fachmann wird es anhand der geforderten Eigenschaften nicht schwer fallen, auch Material für Matrizen auszuwählen, das nicht explizit in dem weiter unten genannten Beispiel genannt wird. Gleiches gilt für die Elastizität des Materiales der Andruckwalzen, welches der Fachmann leicht an die des Matrizenmateriales und die Eigenschaften der mikrostrukturierbaren Oberflächen (z.B.: an die Krümmungsradien, auch bei mehrfach gekrümmten Oberflächen, oder an die Aushärtungseigenschaften im Falle eines Lackes) anpassen kann.

Bevorzugt, insbesondere im Zusammenhang mit dem in dieser Anmeldung beschriebenen Matrizenmaterial, ist ein Oberflächenmaterial für die Andruckwalzen, dessen Shore-Härte von 20 bis 50 liegt. Wiederum bevorzugt besitzen die Andruckwalzen einen Durchmesser von 10 bis 50 cm und/oder eine Länge von 20 bis 100 cm.

Ein wesentlicher Vorteil eines erfindungsgemäßen Werkzeuges ist, dass es eine problemlose und kontinuierliche Bearbeitung von Oberflächen gestattet. Insbesondere bei Auswahl von geeignetem Matrizen- und/oder Andruckwalzenmaterial ist es dazu geeignet, auch gekrümmte, sogar mehrfach gekrümmte Oberflächen zu strukturieren. So lassen sich beispielsweise Großstrukturen wie Flugzeuge oder Schienenfahrzeuge oder Teile davon auch in Bereichen doppelt gekrümmter Flächen mikrostrukturieren. Das erfindungsgemäße Werkzeug, insbesondere eines mit einem Oberflächenmaterial für die Andruckwalze mit einer Shore-Härte von 20 bis 50 und vorzugsweise mit einer Andruckwalze mit einem Durchmesser von 10 bis 50 cm und/oder einer Länge von 20 bis 100 cm, ist daher besonders vorteilhaft zum Mikrostrukturieren von Oberflächen oder Oberflächenabschnitten von Flugzeugen, insbesondere deren Tragflächen und Rumpf, von Schienenfahrzeugen, insbesondere Lokomotiv- und Waggon-Karosserien, Automobilen, Schiffen, insbesondere deren Rümpfe und Antriebsschrauben, Windenergieanlagen, insbesondere deren Rotorblätter, Turbinen, insbesondere deren Rotor- und Statorblätter, und von Rohr-Innenoberflächen, insbesondere für Pipelines. Die eingangs beschriebenen Nachteile herkömmlicher Verfahren zum Bekleben der soeben genannten Oberflächen oder Oberflächenabschnitte können somit vermieden oder verringert werden.

Mehrfach gekrümmte Oberflächen sind im Zusammenhang dieses Textes solche Oberflächen, die nicht faltenfrei von einer durchgehenden, eben ausbreitbaren, mikrostrukturierten Folie nach dem Stand der Technik die gesamte Oberfläche berührend bedeckt werden können.

Wesentlich für eine erfolgreiche Mikrostruktur ist in der Regel auch die Auswahl eines geeigneten Systems aushärtbaren Materials, z.B. eines Lacksystems. Dieses sollte idealerweise ein Zeitfenster bieten, innerhalb dessen der Lack noch verformbar ist und andererseits nach dem Kontakt mit der Matrize nicht mehr verfließt. Gleichzeitig sollte der Lack nicht so klebrig sein, dass er beim Abnehmen der Matrize an dieser kleben bleibt. Da ein solches ideales Lacksystem auch näherungsweise nur technisch aufwendig verwirklichbar ist, wird man oft auf Lacksysteme zurückgreifen, die nicht die beschriebenen idealen Eigenschaften aufweisen. Entscheidend ist, dass der Lack unter der Matrize soweit aushärtet, dass er nicht mehr an dieser klebt und nach Ablösen der Matrize nicht mehr verläuft. Dies kann auch dadurch erreicht werden, dass ein Lacksystem eingesetzt wird, das eine strahlen- oder thermisch induzierte Vernetzungsreaktion aufweist, mittels der der Lack auch unter der Matrize ganz oder teilweise vernetzt werden kann. Solche Lacksysteme eignen sich besonders zur Verwendung mit bevorzugten Ausgestaltungsformen des erfindungsgemäßen Werkzeuges (vgl. weiter unten).

In einer bevorzugten Ausführungsform eines erfindungsgemäßen Werkzeugs ist eine Walze (Abnehmerwalze) so eingerichtet, dass sie beim Verfahren des Werkzeuges über die Oberfläche die Matrize wieder abnimmt.

Wesentliche Vorteile eines solchen bevorzugten erfindungsgemäßen Werkzeugs sind, dass die durch die Rundung der Abnehmerwalze auftretenden Scherkräfte ein Ablösen der Matrize von der mikrostrukturierbaren Oberfläche unterstützten und dass in der Regel kein getrennter Abnahmevorgang für die Matrize mehr notwendig ist.

Bevorzugt umfasst eine obengenannte Vorrichtung zum Beschleunigen des Aushärtens eine Lampe und/oder eine Heizeinrichtung zum Bestrahlen und/oder Beheizen der mikrostrukturierbaren Oberfläche.

Besonders bevorzugt ist dabei, dass die Vorrichtung zum Beschleunigen des Aushärtens eine UV-Lichtquelle ist, da besonders viele UV-aushärtbare Lacke zur Verfügung stehen und eine Bestrahlung mit (UV-) Licht gut handhabbar ist.

Ganz besonders bevorzugt ist ein erfindungsgemäßes Werkzeug, in dem die Vorrichtung zum Beschleunigen des Aushärtens so angebracht ist, dass das Aushärten des aushärtbaren Materials auf der mikrostrukturierbaren Oberfläche durch Durchstrahlen oder Erwärmen der Matrize erfolgt. Dadurch findet das Aushärten im Betrieb schon statt, während die Matrize noch in die mikrostrukturierbare Oberfläche gedrückt ist, so dass ein Verlaufen der Mikrostruktur nach Entfernen der Matrize bei sachgemäßer Handhabung ausgeschlossen werden kann und ein Kleben des aushärtbaren Materials an der Matrize vermieden wird.

Bevorzugt wird das bevorzugte erfindungsgemäße Werkzeug zur Mikrostruktur einer Oberfläche mit einem Lacksystem eingesetzt, das entweder rein strahlungshärtend oder rein thermisch aushärtend ist oder mit einem System, welches eine Kombination aus (a) thermischer und Strahlungshärtung oder (b) einem anderen Aushärtungsmechanismus und (i) Strahlungshärtung oder (ii) thermischer Aushärtung darstellt. Ganz besonders bevorzugt ist in diesem Zusammenhang ein zweikomponentiges sogenanntes Dual-Cure-Lacksystem, das eine Mischung aus zwei unterschiedlichen Aushärtungsmechanismen besitzt:
1. UV-Härtung (radikalische / an-, kationische Polymerisation)
2. Polyol-Isocyanat-Vernetzung (Polyaddition).

Daraus ergeben sich für die Einprägung der Mikrostruktur folgende weitere Vorteile:
1. Es ist gewährleistet, dass die Dual-Cure-Lackschicht auch im Bereich von Schattenzonen im Falle der Aushärtung mittels UV-Lichtes erfolgt
2. Es besteht die Möglichkeit, ein Substrat (Bauteil) komplett zu lackieren und nachfolgend spezifische Zonen des Bauteils zu strukturieren (Einschichtlackierung)
3. Durch das Polyaddukt im Lacksystern wird eine besonders gute Haftung am Substrat erreicht

Eine beispielhafte Rezeptur für ein solches Lacksystem ist weiter unten im Beispiel angegeben.

Ein erfindungsgemäßes Werkzeug und insbesondere deren bevorzugte Ausführungsformen umfassen vorzugsweise eine Vorrichtung zur Aufbringung des aushärtbaren Materials auf ein Substrat oder auf die Matrize. Mit einer solchen Vorrichtung ist es besonders gut möglich, abhängig von den Eigenschaften des aushärtbaren Materials, das die Mikrostruktur bilden soll (z.B. ein Lack), das Mikrostrukturieren auf den Aushärtprozess des aushärtbaren Materials abzustimmen. So ist es möglich, das aushärtbare Material auf die Matrize zu übertragen und es mittels der Matrize auf ein Substrat aufzubringen. Alternativ kann es sinnvoll sein, das aushärtbare Material direkt auf das Substrat aufzutragen und dann vorzugsweise zeitnah mit der Matrize in Berührung zu bringen. In beiden Alternativen wird so zunächst eine mikrostrukturierbare Oberfläche (mittels des aufgetragenen Materials) zur Verfügung gestellt. Unter zeitnah ist dabei in diesem Text ein Zeitintervall zu verstehen, das kürzer ist als die jeweilige Aushärtungszeit für das vollständige (nicht nur teilweise) Aushärten des jeweiligen aushärtbaren Materials, das die Mikrostruktur bilden soll.

Ein weiterer Aspekt der Erfindung betrifft die Verwendung der vorbeschriebenen Werkzeuge zum Erzeugen einer mikrostrukturierten Oberfläche. Durch die Verwendung eines erfindungsgemäßen Werkzeugs zum Erzeugen einer mikrostrukturierten Oberfläche können besonders gut strömungsbegünstigte und/oder Schmutz oder Bewuchs abweisende Oberflächen hergestellt werden, wobei die eingangs für herkömmliche Mikrostrukturierungsverfahren beschriebenen Nachteile vermieden oder verringert werden können. Mit der Verwendung eines erfindungsgemäßen Werkzeugs zum Erzeugen einer mikrostrukturierten Oberfläche können insbesondere die oben zu bevorzugten Ausführungsformen und Aspekten des erfindungsgemäßen Werkzeugs beschriebenen Vorteile erzielt werden.

Die erfindungsgemäßen Werkzeuge (insbesondere in ihren bevorzugten Ausführungsformen) eignen sich besonders für eine solche Verwendung, da mit ihnen in einem kontinuierlichen Prozess große Flächen mikrostrukturiert werden können, die auch doppelt gekrümmte Flächen umfassen können. Dies wird insbesondere ermöglicht durch eine geeignete Auswahl des Matrizenmaterials und des Materials für die Andruckwalze. Das Werkzeug ist darüber hinaus vorzugsweise so gestaltet, dass es den für das Mikrostrukturieren benötigten Druck auf das aushärtbare Material durch sein Eigengewicht ausübt. Der Druck kann jedoch auch durch eine zusätzlich aufgebrachte Kraft erzeugt werden. Dieser Druck ist insbesondere notwendig, um die gegebenenfalls in der Grenzschicht zwischen Werkzeug (Matrize) und mikrostrukturierbarem Material entstehenden Luftblasen zu entfernen.

Dadurch, dass das erfindungsgemäße Werkzeug verfahrbar ist, ist es möglich, durch die Wahl der Vorschubgeschwindigkeit vorteilhafte Präge- und/oder Aushärtebedingungen für das jeweilig gewählte aushärtbare Material, das die Mikrostruktur tragen soll, zu wählen. Dabei kann das Verfahren des Werkzeuges über die mikrostrukturierbare Oberfläche kontinuierlich oder diskontinuierlich erfolgen. Insbesondere bei Verwendung eines geeigneten Matrizenmaterials ist darüber hinaus die Mehrfachverwendung des Werkzeuges möglich, welches bevorzugt so gestaltet ist, dass die Matrize austauschbar ist.

In bevorzugten Ausführungsformen des Werkzeuges lässt sich mittels der Vorrichtung zum Beschleunigen des Aushärtens des aushärtbaren Materials gleichzeitig der Aushärtprozess des aushärtbaren Materials durch das Werkzeug beeinflussen, insbesondere bei Auswahl eines entsprechenden Matrizenmaterials durch Belichtung durch die Matrize hindurch.

Darüber hinaus ist bei der erfindungsgemäßen Verwendung der Einsatz von Lack- bzw. Harzsystemen als aushärtbares Material möglich, die nur unter Ausschluss von Sauerstoff ausgehärtet werden können. Diese Harzsysteme sind technologisch den Systemen, die auch an der Luft z.B. mit UV-Strahlung ausgehärtet werden können, in mancherlei Hinsicht überlegen. Derartige Lack-Harzsysteme bilden insbesondere folgende Vorteile:
- Kein Überschuss von Fotoinitiator ist notwendig, was einen Preisvorteil darstellt und zu einer höheren Dauerhaftigkeit des Lack-Harzfilms führt.
- Es ist kein Überschuss von reaktiven Gruppen notwendig (z.B. Doppelbindung), was die Möglichkeit zur Formulierung von wesentlich flexibleren und weniger spröden Lack-Harzsystemen eröffnet.
- Durch Unterbinden der Sauerstoffinhibierung wird der Lack-Harzfilm im Gegensatz zu herkömmlichen Techniken auch direkt an der Oberfläche nahezu komplett vernetzt, was zu besserer Chemikalien- und Kratzbeständigkeit führt.

Ein weiterer Aspekt der Erfindung betrifft ein Verfahren zum Erzeugen einer wenigstens teilweise mikrostrukturierten Oberfläche, umfassend die Schritte:
a) Bereitstellen einer mikrostrukturierbaren Oberfläche,
b) Bereitstellen eines erfindungsgemäßen Werkzeuges (bevorzugt in einer der bevorzugten Ausgestaltungen),
c) Mikrostrukturieren der Oberfläche mittels des Werkzeuges.

Die bevorzugten Ausgestaltungen der erfindungsgemäßen Verwendung gelten hinsichtlich des erfindungsgemäßen Verfahrens entsprechend.

Bevorzugt wird das erfindungsgemäße Verfahren unter Verwendung eines erfindungsgemäßen Werkzeuges durchgeführt, wobei eine Vorrichtung zum Beschleunigen des Aushärtens des aushärtbaren Materials so angeordnet ist, dass sie beim Verfahren der Andruckwalze über die Oberfläche deren Bewegung begleitet und auf einen (bevorzugt bereits überfahrenen) Teil der Oberfläche einwirkt und damit die mikrostrukturierbare Oberfläche aushärtet. Dadurch kann gewährleistet werden, dass die Mikrostruktur in dem aushärtbaren Material nicht wieder verläuft.

Besonders bevorzugt ist ein erfindungsgemäßes Verfahren, bei dem das Aushärten durch Durchstrahlen oder Erwärmen der Matrize erfolgt. Bei dieser Vorgehensweise ist es möglich, die durch die Matrize erzeugte Mikrostruktur einer Oberfläche eines durch Bestrahlung oder Erwärmung aushärtbarem Material *in situ* so auszuhärten, dass kein Verlaufen mehr erfolgt.

Bevorzugt ist auch ein erfindungsgemäßes Verfahren, umfassend im Schritt b) das Bereitstellen eines erfindungsgemäßen Werkzeuges mit einer Vorrichtung zur Aufbringung des aushärtbaren Materials auf ein Substrat oder auf die Matrize und das Auftragen eines aushärtbaren Materials auf ein Substrat oder auf die Matrize durch das Werkzeug, so dass gemäß Schritt a) eine mikrostrukturierbare Oberfläche bereitgestellt wird.

Der Vorteil dieses Verfahrens liegt darin, dass die Verfahrgeschwindigkeit und die Energie, die von dem besonders bevorzugten erfindungsgemäßen Werkzeug zur Aushärtung des aushärtbaren Materials in dieses eingebracht wird, optimal auf eben dieses Material (bevorzugt ein Lacksystem) abgestimmt werden kann. Darüber hinaus können Auftrag des aushärtbaren Materials (Bereitstellen der mikrostrukturierbaren Oberfläche) und Mikrostrukturieren in einem einzigen Vorgang stattfinden.

Die Erfindung wird nachfolgend anhand von Ausführungsbeispielen unter Bezugnahme auf die beigefügten Figuren erläutert.

Es stellen dar:
- Fig. 1: eine schematische Darstellung eines erfindungsgemäßen Werkzeuges, bei dem die Matrize als Endlosband um die Andruckwalze läuft;
- Fig. 2: eine schematische Darstellung eines erfindungsgemäßen Werkzeuges, bei dem die Matrize als Endlosband um eine Andruck- und eine weitere Walze (Abnehmerwalze) läuft;
- Fig. 3: eine schematische Darstellung eines erfindungsgemäßen Werkzeuges, bei dem die Matrize als Endlosband um die Andruckwalze und zwei weitere Walzen läuft, von denen eine als Abnehmerwalze fungiert;
- Fig. 4: eine schematische Darstellung eines erfindungsgemäßen Werkzeuges, bei dem das Matrizenband von der Andruckwalze abgewickelt und auf eine Abnehmerwalze aufgewickelt wird;
- Fig. 5: die schematische Darstellung eines erfindungsgemäßen Werkzeuges, bei dem die Matrize von einer Walze abgewickelt wird, über die Andruckwalze und eine Abnehmerwalze läuft und danach wieder aufgewickelt wird;
- Fig. 6: das Transmissionsspektrum des im Beispiel verwendeten Matrizenmaterials Elastosil EL M 4648;
- Fig. 7: die spektrale Bestrahlungsstärke der im Beispiel verwendeten UV-Strahlungsquelle im Vergleich zu einem Standard-UV-Strahler.

### Beispiele bevorzugter erfindungsgemäßer Werkzeuge (Fig. 1-5):

In den Figuren 1 - 5 werden identische Bezugszeichen für Elemente verwendet, die einander in ihrer Funktion im Wesentlichen entsprechen.

Das in Figur 1 dargestellte Werkzeug umfasst eine Andruckwalze 1, auf die als Endlosband eine Matrize 3 aufgebracht ist. Innerhalb der Andruckwalze befindet sich eine Licht- und/oder Wärmequelle 5, die so angebracht ist, dass sich die von ihr emittierte Energie durch das Andruckwalzenmaterial hindurch auf die Matrize zu übertragen vermag (im Falle von Wärme) bzw. die die Matrize zu durchstrahlen vermag (im Falle von Licht). Im letztgenannten Fall muss das Walzenmaterial für die von der Lichtquelle emittierte Wellenlänge einen hohen Transmissionsgrad aufweisen.

Ein weiteres erfindungsgemäßes Werkzeug, wie es in Figur 2 dargestellt ist, umfasst eine Andruckwalze 1, eine Matrize 3, die wiederum als Endlosband ausgestaltet ist und eine Walze 7, die gleichzeitig als Abnehmerwalze fungiert. Bei einem Werkzeug dieser Anordnung kann ein Aushärtmittel (z.B. eine Lichtquelle) innerhalb des umlaufenden oder oberhalb des umlaufenden Matrizenbandes optional angebracht werden.

Figur 3 stellt ein erfindungsgemäßes Werkzeug dar mit einer Andruckwalze 1, einer Matrize 3, einer Walze 7, die gleichzeitig als Abnehmerwalze fungiert und einer Walze 9 sowie einer Belichtungsquelle mit variabler Abstandseinstellung 5a (optional).

Figur 4 stellt eine weitere Ausführungsform eines erfindungsgemäßen Werkzeuges dar, bei dem eine bahnförmige Matrize 3 von Andruckwalze 1 abgerollt und auf eine Walze 7, die gleichzeitig als Abnehmerwalze fungiert, aufgerollt wird.

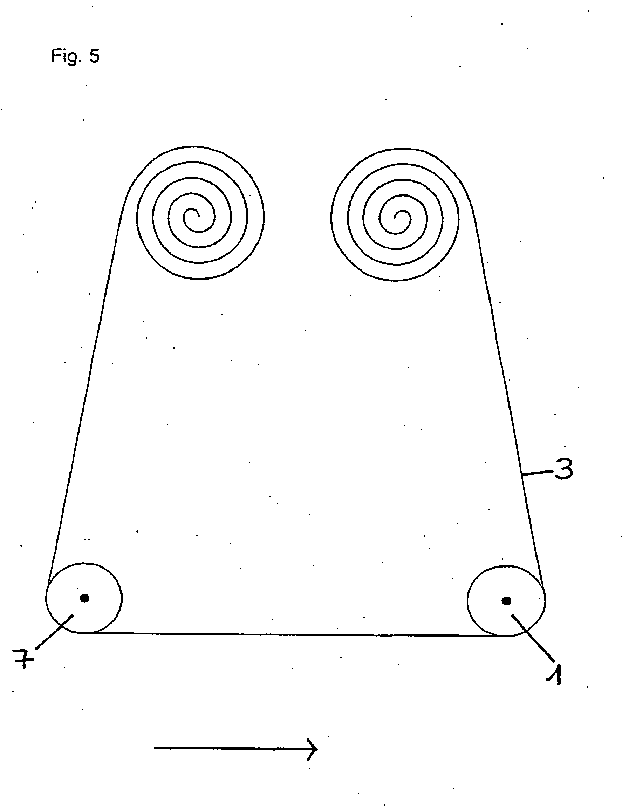

Figur 5 stellt ein weiteres erfindungsgemäßes Werkzeug dar, bei dem eine bahnförmige Matrize 3 von einer (nicht dargestellten) Rolle oder dergleichen abgerollt, über eine Andruckwalze 1 geführt und von einer Abnehmerwalze 7 wiederum von der Oberfläche abgenommen wird, bevor sie wiederum auf eine (nicht dargestellte) Rolle oder dergleichen aufgerollt wird. Wie in Figur 4 ist die Matrize nicht als Endlosband gestaltet.

Die Verfahrrichtung entspricht der in der jeweiligen Figur dargestellten Pfeilrichtung. Eine Vorrichtung zum Beschleunigen der Aushärtung des aushärtbaren Materials (zum Teil nicht dargestellt) kann oberhalb oder zwischen den Walzen (wenn mehr als eine vorhanden sind) optional angebracht werden. Die erfindungsgemäßen Werkzeuge können auch so gestaltet sein, dass abhängig von der Verfahrrichtung jeweils die selbe Walze als Andruck- oder Abnehmerwalze wirken kann.

### Beispiel für Werkzeugherstellung und Verfahrensdurchführung

Für ein erfindungsgemäßes Werkzeug, das der Ausgestaltung gemäß Figur 3 inklusive einer Belichtungsquelle mit variabler Abstandseinstellung entspricht, wurde eine Matrize aus einem Material gemäß nachfolgendem Unterpunkt a) als Endlosband wie nachfolgend unter b) beschrieben hergestellt: Das so hergestellte Werkzeug wurde wie im Unterpunkt e) beschrieben eingesetzt, wobei mittels einer UV-Lampe (beschrieben im Unterpunkt d) ein Lack mikrostrukturiert wurde (Lacksystem vgl. Unterpunkt c)).

### a) Material zur Herstellung der Matrize:

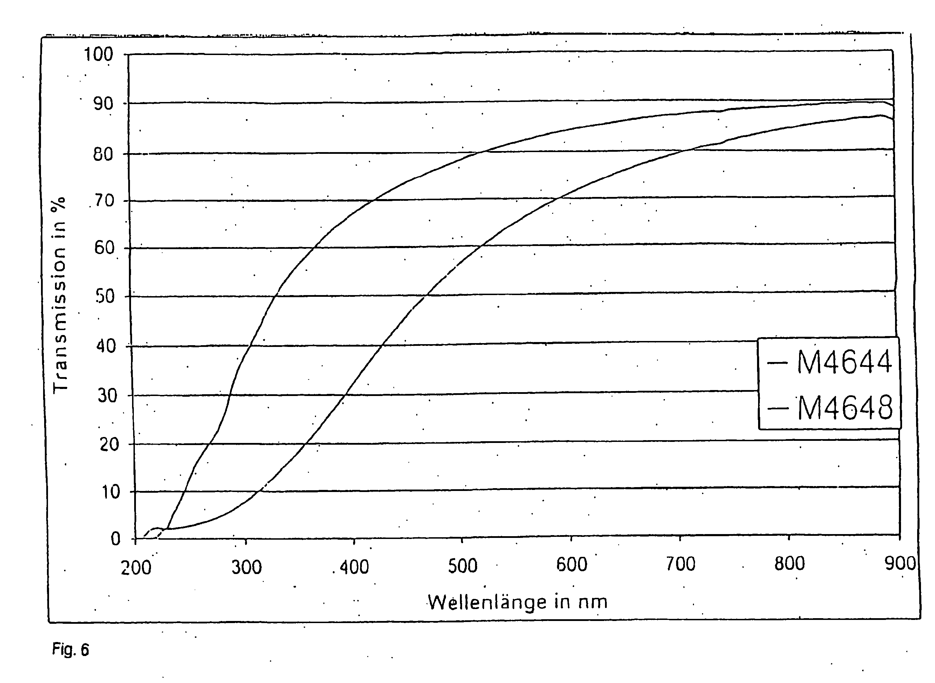

Es wurde eine zweikomponentige, auf Basis von Polyaddition aushärtende Silikon-Abformmasse der Firma Wacker verwendet Bei dieser handelt es sich um die transparente 2K-Silikon-Abformmasse Elastosil EL M 4648 mit einem Mischungsverhältnis von 10 zu 1 (Komponente A zu Komponente B) der Firma Wacker. Das Transmissionsspektrum von Elastosil EL M 4648 ist in Ausschnitten in Tabelle 1 niedergelegt und findet sich in der Figur 6 im Vergleich zu der Abformmasse Elastosil EL M 4644 der Firma Wacker abgebildet.

**Tabelle 1: Transmissionsspektrum des Matrizenmaterials Elastosil EL M 4648**

| **Wellenlänge [nm]** | **Transmission [%]** |
|---|---|
| 200 | 0,05 |
| 250 | 2,69 |
| 300 | 7,93 |
| 350 | 18,36 |
| 400 | 31,64 |

### b) Herstellung der Matrize

Die Matrize sollte die bekannte, strömungsgünstige Mikrostruktur, die bereits für Verkehrsflugzeuge erprobt ist, ausweisen. Zu diesem Zweck wurden Negativ-Kopien einer Folie mit der erprobten Mikrostruktur angefertigt, indem diese Folie mit dem oben angegebenen Silikonmaterial abgeformt wurde Um eine ausreichende Abformung und geringe Rissneigung der Matrize zu gewährleisten, wurde die Matrizendicke auf mindestens 1 mm eingestellt Dabei wurde folgendermaßen vorgegangen:
- Die Original-Folie (mit der erprobten Mikrostruktur) wurde auf einem ebenen Grund fixiert.
- Die oben genannte Silikon-Abformmasse wurde im erwähnten Mischungsverhältnis angemischt und mittels dafür vorhergesehener Apparaturen (hier ein Vakuumdissolver) entlüftet.
- Die Silikon-Abformmasse wurde auf die Original-Folie in der oben genannten Schichtdicke aufgegeben.
- Die Aushärtzeit betrug mindestens 12 Stunden.
- Nach dem Aushärten wurde die so entstandene Silikonmatrize 3 von der Original-Folie abgezogen, zu einem Endlosband zusammengefügt und zu einem Werkzeug mit den anderen Bestandteilen eines erfindungsgemäßen Werkzeuges, wie in Figur 3 schematisch abgebildet, zusammengefügt.

In einigen Fällen wurde die Silikonabformmasse mittels einer Vakuumvorrichtung nach dem Auftragen der Abformmasse auf die Original-Folie entlüftet.

### c) Aushärtbares Material

Für den speziellen Anwendungsfall wurde ein zweikomponentiges sogenanntes Dual-Cure-Lacksystem entwickelt, also ein Lacksystem, das über zwei unterschiedliche Aushärtungsmechanismen ausgehärtet werden kann:
1. UV-Härtung (radiakalische / an-/, kationische Polymerisation)
2. Polyol-Isocyanat-Vernetzung (Polyaddition).

| **Rezepturen: Komponente A** | | |
|---|---|---|
| **Nr.** | **Rohstoff** | **Gew.-%.** |
| 1 | Desmophen A 870 BA | 52,60 |
| 2 | Baysilone OL 17 | 0,50 |
| 3 | Modaflow | 0,50 |
| 4 | 1-Methoxypropylacetat-2/ Solvesso 100 (1:1) | 10,50 |
| 5 | Genomer 3364 | 14,95 |
| 6 | Irgacure 184 | 0,80 |
| 7 | Irgacure 907 | 0,15 |
| | | |
| | | **80,00** |

| **Komponente B** | | |
|---|---|---|
| 1 | Desmodur N 3390 | 20,00 |
| | | **20,00** |
| | | |
| **Gesamt** | | **100,00** |

### Komponente A:

1. Hydroxylfunktionelles Polyacrylat
2. Polyether modifiziertes Polysiloxan
3. Fließmittel
4. Lösungsmittel
5. Modifiziertes Polyetherpolyoacrylat
6. Photoinitiator: 2-Methyl-1[4-(methoylthio)phenyl]-2-morpholinopropan-1-on
7. Photoinitiator: 1-Hydroxy-cyclohexyl-phenyl-keton

### Komponente B:

Aliphatisches Hexamethylendiisocyanat (HDI)

Aushärtungsparameter des Lacksystems:
- UV-Härtung: Lichtstärke: 100% (4 kW), v_{Durchlauf}=1,4 m/min
- NCO-Vernetzung: bei Raumtemperatur

### d.) Strahlungsquelle:

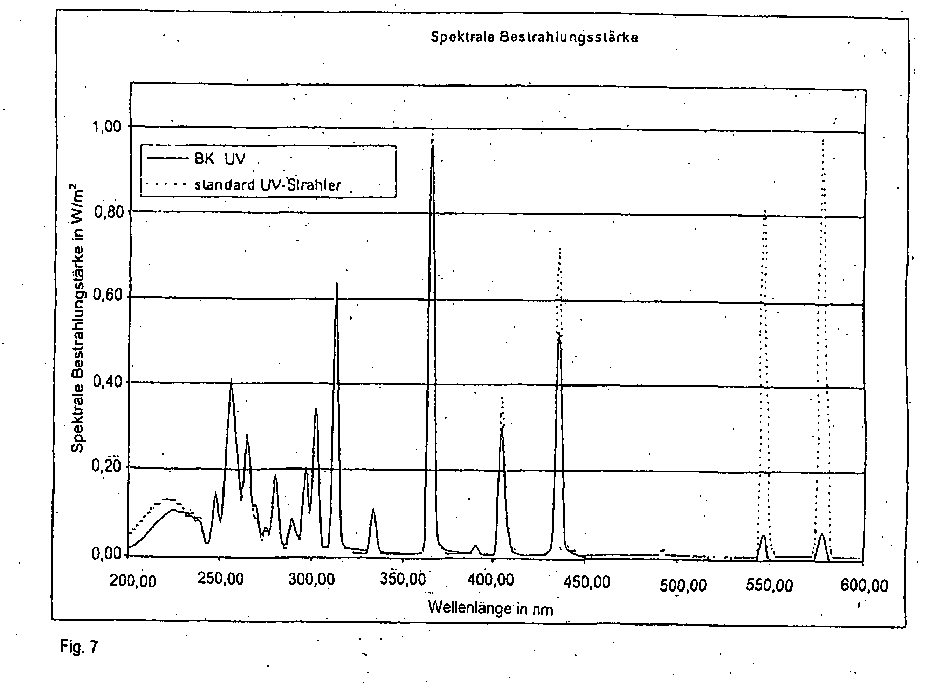

Zum Aushärten der UV-empfindlichen Stoffkomponente des Dual-Cure-Lackes wurde eine UV-Strahlungsquelle (5a) verwendet. Das Gerät war so montiert, dass der Austritt von UV-Licht und Ozon minimiert war. Die Strahlungsquelle besteht aus einer Quecksilberdampf-Metall-Halogenidlampe, die im Betrieb ultraviolettes Licht im A-, B- und C-Bereich ausstrahlt. Das UV-Licht wurde durch mehrere Reflektoren umgelenkt und auf ein Lichtspektrum im UV-Bereich von 200 bis 400 nm selektiert, bevor es austrat. Die unerwünschten Anteile der Energie von sichtbarem und infrarotem Licht von 400 bis 4000 nm wurden über das Kühlgehäuse abgeführt. Figur 7 stellt die spektrale Bestrahlungsstärke der verwendeten UV-Strahlungsquelle (5a) im Vergleich zu einem Standard-UV-Strahler dar. Die maximale Intensität der verwendeten UV-Lampen betrug 4kW, die Wellenlängenverteilung des eingesetzten UV-Lichtes: 200 bis 400nm.

### e.) Mikrostrukturieren einer Oberfläche eines Substrates und Aushärten mittels des Werkzeuges:

Der erwähnte Dual-Cure-Lack wurde mit einer durchschnittlichen Schichtdicke von ca. 70µm auf das Substrat ein mit Epoxyprimer versehenes, chromsäureanodisiertes Aluminiumblech der Größe 10 x 20 cm aufgetragen. Dadurch war die Lackschichtdicke größer als die Tiefe der zu erzeugenden Mikrostruktur. Nach dem Auftragen des Lackes wurde das Werkzeug auf die Lackschicht (Oberfläche) gelegt und die Luft durch leichten Druck aus der Zwischenschicht entfernt. Anschließend wurde der Lack durch das Werkzeug mittels des UV-Lichtes ausgehärtet, wobei das UV-Licht aus der UV-Lichtquelle austrat und durch die Matrize hindurch auf den auszuhärtenden Lack traf. Die UV-Lampe wurde mit maximaler Intensität betrieben (4kW) und das Werkzeug mit einer Verfahrgeschwindigkeit von v = 1,4 m/min über die mikrostrukturierbare Oberfläche entsprechend der Pfeilrichtung in Figur 3 verfahren. Bedingt durch die kontinuierliche Fortbewegung des gesamten Werkzeuges und die an der Walze 7 auftretenden Scherwirkungen wurde die Matrize nach der Aushärtung sofort von der Lackschicht entfernt. Bei Einsatz von Gummiwalzen (1, 7, 9) war es möglich, auch mehrfach gekrümmte Oberflächen zu mikrostrukturieren.

## Patentansprüche

1. Werkzeug zum Erzeugen einer mikrostrukturierten Oberfläche, umfassend:
- eine Matrize (3) mit einem Negativ der zu erzeugenden Mikrostruktur,
- eine Andruckwalze (1) zum Andrücken der Matrize an die Oberfläche,
**dadurch gekennzeichnet, dass**
die Andruckwalze (1) über eine Oberfläche verfahrbar ist,
Andruckwalze (1) und Matrize (3) so angeordnet sind, dass beim Verfahren der Walze (1) über die Oberfläche die Matrize (3) in einen rollenden Bewegung zwischen Walze (1) und Oberfläche gelangt, so dass das Negativ der Matrize (3) der Oberfläche zugewandt ist, und
eine Vorrichtung (5) zum Beschleunigen des Aushärtens eines aushärtbaren Materials so angeordnet ist, dass sie beim Verfahren der Andruckwalze (1) über die Oberfläche deren Bewegung begleitet und auf einen Teil der Oberfläche einwirkt.

2. Werkzeug nach Anspruch 1, wobei das die Matrize (3) bildende Material eine Shore-Härte von 25 - 40 besitzt.

3. Werkzeug nach Anspruch 1 oder 2, wobei eine Walze (7) so eingerichtet ist, dass sie beim Verfahren des Werkzeuges über die Oberfläche die Matrize (3) wieder abnimmt.

4. Werkzeug nach einem der vorangehenden Ansprüche, wobei das Oberflächenmaterial der Andruckwalze (1) eine Shore-Härte von 20 bis 50 besitzt und vorzugsweise einen Durchmesser von 10 - 50 cm und/oder eine Länge von 20-100 cm aufweist.

5. Werkzeug nach einem der vorangehenden Ansprüche, wobei das Werkzeug so eingerichtet ist, dass damit die Mikrostrukturierung doppelt gekrümmter Flächen, bevorzugt an Großstrukturen wie Flugzeugen, Schienenfahrzeugen, Schiffen, insbesondere deren Rümpfen, und/oder Windenergieanlagen, insbesondere deren Rotorblättern, ermöglicht ist.

6. Werkzeug nach einem der vorangehenden Ansprüche, wobei die Vorrichtung (5) zum Beschleunigen des Aushärtens eine Lampe und/oder eine Heizeinrichtung zum Bestrahlen und/oder Beheizen der mikrostrukturierbaren Oberfläche umfasst.

7. Werkzeug nach Anspruch 6, wobei die Lampe (5) eine UV-Lichtquelle ist.

8. Werkzeug nach Anspruch 6 oder 7, wobei die Vorrichtung (5) zum Beschleunigen des Aushärtens so angebracht ist, dass das Aushärten des aushärtbaren Materials auf der mikrostrukturierbaren Oberfläche durch Durchstrahlen oder Erwärmen der Matrize (3) erfolgt.

9. Werkzeug nach einem der vorangehenden Ansprüche, wobei das Werkzeug eine Vorrichtung zur Aufbringung des aushärtbaren Materials auf ein Substrat oder auf die Matrize umfasst.

10. Verwendung eines Werkzeuges nach einem der vorangehenden Ansprüche zum Erzeugen einer mikrostrukturierten Oberfläche.

11. Verfahren zum Erzeugen einer wenigstens teilweise mikrostrukturierten Oberfläche, umfassend die Schritte:
a) Bereitstellen einer mikrostrukturierbaren Oberfläche,
b) Bereitstellen eines Werkzeuges nach einem der Ansprüche 1-9.
c) Mikrostrukturieren der Oberfläche mittels des Werkzeuges.

12. Verfahren nach Anspruch 11, umfassend im Schritt b) das Bereitstellen eines Werkzeuges nach einem der Ansprüche 1-9 und eine Aushärtung des aushärtbaren Materials auf der mikrostrukturierbaren Oberfläche durch das Werkzeug.

13. Verfahren nach Anspruch 12, wobei die Aushärtung durch Durchstrahlen oder Erwärmen der Matrize (3) erfolgt.

14. Verfahren nach einem der Ansprüche 11 - 13, umfassend im Schritt b) das Bereitstellen eines Werkzeuges nach Anspruch 9 und das Auftragen eines aushärtbaren Materials auf ein Substrat oder auf die Matrize (3) durch das Werkzeug, so dass gemäß Schritt a) eine mikrostrukturierbare Oberfläche bereitgestellt wird.

## Claims

1. Tool for producing a microstructured surface, comprising:
- a die (3) having a negative to the microstructure to be produced,
- a pressing roll (1) for pressing the die against the surface,
**characterised in that**
the pressing roll (1) can be moved across a surface, the pressing roll (1) and die (3) are positioned such that when the roll (1) is moved across the surface, the die (3) assumes a rolling motion between the roll (1) and the surface such that the negative of the die (3) is facing the surface, and
a device (5) for accelerating the curing of a curable material is positioned such that when the pressing roll (1) is moved across the surface, said device follows its movement and acts upon a part of the surface.

2. Tool according to claim 1, wherein the material forming the die (3) has a Shore hardness of 25 to 40.

3. Tool according to claim 1 or 2, wherein a roll (7) is arranged such that it lifts the die (3) up again when the tool is moved across the surface.

4. Tool according to one of the preceding claims, wherein the surface material of the pressing roll (1) has a Shore hardness of 20 to 50 and preferably a diameter of 10 to 50 cm and/or a length of 20 to 100 cm.

5. Tool according to one of the preceding claims, wherein the tool is arranged such that the microstructuring of double-curved surfaces, preferably on large structures such as aircraft, rail vehicles, ships, in particular the hulls thereof, and/or wind turbines, in particular the rotor blades thereof, is possible with said tool.

6. Tool according to one of the preceding claims, wherein the device (5) for accelerating the curing is a lamp and/or a heating device for irradiating and/or heating the microstructurable surface.

7. Tool according to claim 6, wherein the lamp (5) is a UV light source.

8. Tool according to claim 6 or 7, wherein the device (5) for accelerating the curing is installed such that curing of the curable material on the microstructurable surface is performed by irradiation or heating of the die (3).

9. Tool according to one of the preceding claims, wherein the tool includes a device for applying the curable material to a substrate or to the die.

10. Use of a tool according to one of the preceding claims to produce a microstructured surface.

11. Process for producing an at least partly microstructured surface comprising the following steps:
a) Provision of a microstructurable surface
b) Provision of a tool according to one of claims 1 to 9,
c) Microstructuring of the surface by means of the tool.

12. Process according to claim 11, comprising in step b) the provision of a tool according to one of claims 1 to 9 and curing of the curable material on the microstructurable surface by means of the tool.

13. Process according to claim 12, wherein curing is performed by irradiation or heating of the die (3).

14. Process according to one of claims 11 to 13, comprising in step b) the provision of a tool according to claim 9 and the application of a curable material to a substrate or to the die (3) by means of the tool, such that a microstructurable surface is provided according to step a).

## Revendications

1. Outillage pour produire une surface microstructurée, comprenant
- une matrice (3) avec un négatif de la microstructure à produire,
- un rouleau-presseur (1) pour appliquer par pressage la matrice sur la surface,
**caractérisé**
**en ce que** le rouleau-presseur (1) peut être déplacé par-dessus une surface,
**en ce que** le rouleau-presseur (1) et la matrice (3) sont agencés de façon que lors du déplacement du rouleau (1) par-dessus la surface, la matrice (3) effectue un mouvement de roulement entre le rouleau (1) et la surface, de manière à ce que le négatif de la matrice (3) soit dirigé vers la surface, et
**en ce qu'**un dispositif (5) pour accélérer le durcissement d'un matériau durcissable est agencé de façon telle, que lors du déplacement du rouleau-presseur (1) par-dessus la surface, il accompagne le mouvement de ce dernier et agit sur une partie de la surface.

2. Outillage selon la revendication 1, dans lequel le matériau formant la matrice (3) possède une dureté Shore de 25 - 40.

3. Outillage selon la revendication 1 ou 2, dans lequel un rouleau (7) est arrangé de façon telle, que lors du déplacement de l'outillage par-dessus la surface, il retire à nouveau la matrice (3) de cette surface.

4. Outillage selon l'une des revendications précédentes, dans lequel le matériau de surface du rouleau-presseur (1) présente une dureté Shore de 20 à 50 et de préférence un diamètre de 10 - 50 cm et/ou une longueur de 20 - 100 cm.

5. Outillage selon l'une des revendications précédentes, dans lequel l'outillage est arrangé de façon à ce qu'il permette de réaliser la micro-structuration de surfaces à courbure double, de préférence sur des grosses structures telles que des avions, des véhicules sur rails, des navires, notamment les corps, fuselages, carcasses ou coques de ceux-ci, et/ou des installations éoliennes, notamment les pales de rotor de celles-ci.

6. Outillage selon l'une des revendications précédentes, dans lequel le dispositif (5) pour accélérer le durcissement, comprend une lampe et/ou un dispositif de chauffage pour irradier par rayonnement et/ou chauffer la surface pouvant être microstructurée.

7. Outillage selon la revendication 6, dans lequel la lampe (5) est une source de lumière UV.

8. Outillage selon la revendication 6 ou 7, dans lequel le dispositif (5) pour accélérer le durcissement est agencé de manière à ce que le durcissement du matériau durcissable sur la surface pouvant être microstructurée, s'effectue par rayonnement à travers la matrice (3) ou par chauffage de cette dernière.

9. Outillage selon l'une des revendications précédentes, dans lequel l'outillage englobe un dispositif pour l'application du matériau durcissable sur un substrat ou sur la matrice.

10. Utilisation d'un outillage selon l'une des revendications précédentes, pour produire une surface microstructurée.

11. Procédé pour produire une surface au moins partiellement microstructurée, englobant les étapes suivantes :
a) mise à disposition d'une surface pouvant être microstructurée,
b) mise à disposition d'un outillage selon l'une des revendications 1 - 9,
c) micro-structuration de la surface au moyen de l'outillage.

12. Procédé selon la revendication 11, comprenant dans l'étape b) la mise à disposition d'un outillage selon l'une des revendications 1 - 9 et un durcissement du matériau durcissable sur la surface pouvant être microstructurée par l'outillage.

13. Procédé selon la revendication 12, d'après lequel le durcissement est effectué par rayonnement à travers la matrice (3) ou chauffage de celle-ci.

14. Procédé selon l'une des revendications 11 - 13, comprenant dans l'étape b) la mise à disposition d'un outillage selon la revendication 9 et l'application d'un matériau durcissable sur un substrat ou sur la matrice (3) par l'outillage, de sorte que, conformément à l'étape a), est mise à disposition une surface pouvant être microstructurée.
